# FASCICULE DE BREVET EUROPEEN

(11) **EP 1 046 043 B1**
(45) Date de publication et mention de la délivrance du brevet: **08.09.2004**
(21) Numéro de dépôt: 99941713.2
(22) Date de dépôt: 08.09.1999
(51) Int. Cl.: G01R 15/18

(54) **BOBINAGE TORIQUE SANS NOYAU MAGNETIQUE COMPORTANT DEUX ENROULEMENTS SUPERPOSES**
KERNLOSE TORUSFÖRMIGE SPULE MIT ZWEI ÜBEREINANDER ANGEORDNETEN WICKLUNGEN
TOROIDAL COIL WITHOUT MAGNETIC CORE COMPRISING TWO SUPERPOSED WINDINGS

(30) Priorité: 09.09.1998 FR 9811245
(43) Date de publication de la demande: 25.10.2000
(73) Titulaire: ALSTOM Holdings, 75116 Paris (FR)
(72) Inventeur: LUCOT, Lionel, F-69210 Fleurieux l'Arbresle (FR); MONCORGE, Jean-Paul, F-69210 Vaux en Velin (FR)
(74) Mandataire: Poulin, Gérard
(86) Numéro de dépôt international: PCT/FR1999/002130
(87) Numéro de publication internationale: WO 2000/014551

(56) Documents cités:
- DE-A- 2 656 817
- FR-A- 2 471 034
- FR-A- 2 559 268
- US-A- 3 449 703
- US-A- 5 642 041
- US-A- 5 692 483
- LABUHN F ET AL: "STROMMESSUNGEN AN IMPULSENDADUNGEN MIT ROGOWSKI-SPULEN" 1 juin 1971 (1971-06-01) , MESSTECHNIK, VOL. 79, NR. 6, PAGE(S) 127 - 134 XP002066091
- NALTY K E ET AL: "INSTRUMENTATION FOR EM LAUNCHER SYSTEMS" IEEE TRANSACTIONS ON MAGNETICS, vol. MAG-20, no. 2, 1 mars 1984 (1984-03-01), pages 328-331, XP002066090

## Description

L'invention se rapporte à un bobinage torique sans noyau magnétique, du type d'un tore de Rogowski, qui comprend un support isolant et un fil conducteur qui est bobiné sur le support isolant suivant un certain sens de rotation et d'une extrémité initiale à une extrémité finale du support pour former un premier enroulement de spires jointives.

Un tel tore de Rogowski est utilisé pour déterminer l'intensité d'un courant électrique transporté par un conducteur. On monte le tore autour du conducteur et on mesure à l'aide d'un intégrateur, une tension qui est proportionnelle à l'intensité du courant électrique. L'absence de noyau magnétique saturant le système permet une large dynamique de mesure, de 1 ampère à plusieurs dizaines de kilo-ampères.

Pour obtenir une mesure de tension indépendante par rapport à la position du conducteur dans l'anneau intérieur du tore et pour supprimer l'influence d'un autre conducteur placé à l'extérieur du tore, il est nécessaire d'une part, de bobiner le fil autour du tore de façon telle à former un enroulement de spires jointives réparties de façon homogène le long du tore. D'autre part, le tore en lui-même constitue une spire parasite qui capte des champs magnétiques dirigés suivant l'axe central perpendiculaire au plan du tore, et il est nécessaire de compenser cette influence sur la mesure de la tension proportionnelle au courant électrique du conducteur.

D'une manière connue, la compensation de la spire constituée par le tore lui-même est obtenue en réalisant un retour du fil conducteur de l'extrémité finale vers l'extrémité initiale du tore, à l'intérieur des spires de l'enroulement. Le retour du fil conducteur forme une spire dont le diamètre est égal au diamètre moyen du tore.

Cet agencement se révèle pourtant non dépourvu d'inconvénient. En particulier, la spire de retour permet de supprimer l'influence parasite de la spire constituée par le tore lui-même seulement si elle est centrée par rapport au centre du tore. En pratique, le fil conducteur est disposé exactement au centre de chaque spire de l'enroulement, mais cet agencement s'obtient au prix d'une construction relativement compliquée du support isolant comportant par exemple des disques intérieurs percés en leur centre pour supporter le fil conducteur.

Le but de l'invention est de d'améliorer la protection vis à vis de champs magnétiques parasites d'un bobinage sans noyau magnétique du type d'un tore de Rogowski.

A cet effet, l'invention a pour objet un bobinage torique sans noyau magnétique, du type d'un tore de Rogowski, qui comprend un support isolant et un fil conducteur qui est bobiné sur le support isolant suivant un certain sens de rotation et d'une extrémité initiale à une extrémité finale du support pour former un premier enroulement de spires jointives, caractérisé en ce que le fil conducteur est bobiné sur le support isolant suivant le même sens de rotation et de l'extrémité finale vers l'extrémité initiale du support pour former un deuxième enroulement de spires jointives superposé au premier enroulement.

Le deuxième enroulement superposé au premier forme un retour du fil conducteur qui est centré par rapport au centre du tore pour compenser la spire constituée par le tore lui-même. Le bobinage du deuxième enroulement est simple à réaliser et s'obtient à l'aide des mêmes moyens que ceux utilisés pour le bobinage du premier enroulement. Le support isolant n'a pas à être pourvu de disques intérieurs, et les deux enroulements superposés confèrent au tore une plus grande solidité qu'un retour du fil conducteur par une spire unique.

Selon un premier avantage de l'invention, le deuxième enroulement est superposé au premier de façon telle que chaque spire du deuxième enroulement s'appuie sur deux spires jointives du premier enroulement. Cet agencement accroît la stabilité du bobinage des deux enroulements, et confère une plus grande durée de vie au tore.

Selon un deuxième avantage de l'invention, un deuxième fil conducteur est bobiné autour du support isolant pour former un troisième enroulement de spires superposé aux premier et deuxième enroulements. Ce troisième enroulement forme un bobinage de test qui permet de simuler la présence d'un conducteur placé dans l'anneau intérieur du tore et transportant une intensité donnée en courant électrique.

Pour effectuer la simulation, on injecte un courant dans le bobinage de test de manière à créer dans les premier et deuxième enroulements un nombre d'ampères-tours égal à l'intensité du courant électrique transporté par le conducteur. La tension délivrée par le bobinage de mesure que constituent les premier et deuxième enroulements est proportionnelle au nombre d'ampères-tours créés par le courant de test. Comme ce nombre d'ampères-tours est égal au produit du courant de test et du nombre de spires du troisième enroulement, le courant de test à injecter est divisé par le nombre de spires, soit en pratique un rapport de 100 à 1000 par rapport à l'intensité transportée par le conducteur.

La simulation permet ainsi d'étalonner le tore en laboratoire et de le ré-étalonner périodiquement sur site avec une grande facilité. Elle permet également de contrôler l'ensemble constitué par le tore et l'intégrateur.

D'autres caractéristiques et avantages de l'invention apparaîtront à la lecture de la description d'un mode de réalisation illustré par les dessins.

La figure 1 montre en coupe transversale un tore selon l'invention déplié suivant une direction longitudinale.

La figure 2 montre un dispositif de fabrication du tore présenté à la figure 1.

La figure 3 illustre un montage pour étalonner un tore selon l'invention.

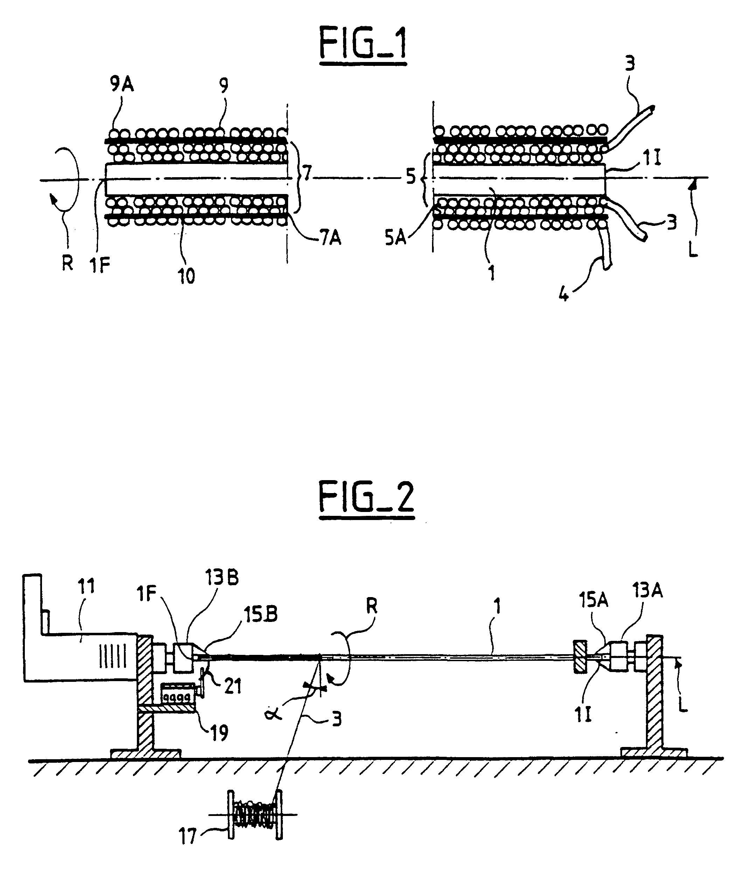

Un bobinage comprend, figure 1, un tuyau en matière plastique qui s'étend suivant une direction longitudinale L. Un fil de cuivre souple 3 est bobiné autour du support isolant 1 suivant un sens de rotation R et d'une extrémité initiale 1I à une extrémité finale 1F du support isolant 1. Le bobinage du fil de cuivre forme un premier enroulement 5 de spires jointives 5A qui sont réparties de façon homogène le long du support isolant 1. On ferme le tuyau sur lui-même en mettant en coïncidence les deux extrémités 1I et 1F pour former un bobinage torique sans noyau magnétique du type d'un tore de Rogowski.

Selon l'invention, le fil de cuivre souple 3 est bobiné sur le support isolant 1 suivant le même sens de rotation R et à partir de l'extrémité finale 1F jusqu'à l'extrémité initiale 1I pour former un deuxième enroulement 7 superposé au premier enroulement 5. Les spires 7A du deuxième enroulement 7 sont jointives et réparties uniformément le long du tuyau en matière plastique 1.

Comme indiqué précédemment, le deuxième enroulement 7 superposé au premier 5 forme un retour du fil de cuivre souple 3 qui est centré par rapport au centre du tore pour compenser la grande spire constituée par le tore lui-même. De cette façon, le tore selon l'invention est insensible à des champs magnétiques parasites orientés perpendiculairement au plan du tore. Le deuxième enroulement 7 annule également l'influence de la position d'un conducteur placé dans l'anneau intérieur du tore, sur la tension délivrée par le tore proportionnellement à l'intensité du courant électrique qui est transporté par le conducteur.

Il faut noter également que le deuxième enroulement augmente d'un facteur 2 la sensibilité du tore selon l'invention, pour un encombrement identique.

Le bobinage du deuxième enroulement 7 est simple à réaliser et s'obtient à l'aide des mêmes moyens que ceux utilisés pour le bobinage du premier enroulement 5. Un dispositif de bobinage comprend, figure 2, un moteur 11 pour entraîner en rotation R le tuyau en matière plastique 1 tendu entre deux mandrins 13A et 13B alignés suivant la direction longitudinale L.

Pour éviter d'écraser le tuyau dans les mors 15A et 15B des mandrins, on insère un corps cylindrique à chaque extrémité 1I et 1F du support isolant 1.

Une bobine 17 délivre le fil de cuivre 3 qui est entraîné par la rotation du support 1 pour s'enrouler autour et former les premier et deuxième enroulement 5 et 7 de spires jointives 5A et 7A. Au départ du bobinage du premier enroulement 5, le fil de cuivre est collé par un ruban adhésif sur l'extrémité initiale 1l du support 1. Pour enrouler les spires de façon jointive, le fil de cuivre est délivré par la bobine 17 avec une légère inclinaison α en retrait par rapport à la dernière spire formée.

Pour réaliser le deuxième enroulement 7 superposé au premier 5, on colle la dernière spire du premier enroulement avec un ruban adhésif, puis on entraîne à nouveau en rotation le tuyau 1 dans le même sens de rotation R que celui utilisé pour le premier enroulement 5.

Le comptage des spires 5A et 7A des premier et deuxième enroulements 5 et 7 est effectué par un compteur mécanique 19 actionné par un ergot 21 pris dans les mors 15B d'un des deux mandrins.

La fin du bobinage dépend du nombre total de spires effectivement enroulées par rapport au nombre total de spires désiré.

Si le deuxième enroulement rejoint le début du premier enroulement avant que le nombre total de spires désiré soit atteint, on bobine alors les spires manquantes pour moitié sur chaque enroulement. Si le deuxième enroulement ne rejoint pas le début du premier enroulement alors que le nombre total de spires est atteint, les spires non superposées par le deuxième enroulement sont débobinées pour moitié et bobinées en superposition au deuxième enroulement.

On relève que le deuxième enroulement est centré sur le premier enroulement d'une façon sure et simple. Le support isolant n'a pas à être pourvu de disques intérieurs, et les deux enroulements superposés confèrent au tore une plus grande solidité qu'un retour du fil de cuivre par une spire unique.

Selon un premier avantage de l'invention, le deuxième enroulement 7 est superposé au premier enroulement 1 de façon telle que chaque spire 7A du deuxième enroulement s'appuie sur deux spires jointives 5A du premier enroulement. Cet agencement accroît la stabilité du bobinage des deux enroulements, et confère une plus grande durée de vie au tore. On parvient à ce résultat en effectuant un bobinage à vitesse de rotation plus lente que dans le cas précédent.

Selon un deuxième avantage de l'invention, figure 1, un deuxième fil de cuivre souple 4 est bobiné autour du tuyau en matière plastique 1 pour former un troisième enroulement 9 de spires superposé 9A aux premier et deuxième enroulements 5 et 7.

De préférence, le deuxième 7 et le troisième 9 enroulements sont séparés par une gaine isolante 10 rétractable par chauffage qui est mise en place après le bobinage des premier et deuxième enroulement 5 et 7.

Le bobinage du troisième enroulement 9 est mis en oeuvre par le dispositif décrit précédemment d'une façon identique aux premier et deuxième enroulements. Les spires 9A sont jointives ou espacées les unes des autres, étant entendu que le nombre d'ampères-tours générés par le troisième enroulement 9 ne dépend que de l'intensité du courant injecté dans l'enroulement et du nombre de spires. Il est prévu de bobiner des spires supplémentaires sur un troisième enroulement 9 de spires jointives 9A pour augmenter le nombre d'ampères-tours.

On met en place une deuxième gaine isolante rétractable par chauffage après le bobinage du troisième enroulement et on referme le tuyau en mettant en coïncidence ses deux extrémités que l'on colle sur l'un des corps cylindriques insérés. On obtient un tore que l'on surmoule dans une résine thermodurcissable.

Comme indiqué précédemment, le troisième enroulement 9 forme un bobinage de test qui permet de simuler un conducteur placé dans l'anneau intérieur du tore et transportant une intensité donnée de courant électrique.

Le bobinage de test est particulièrement avantageux pour réaliser un étalonnage du tore. Par cette opération, on détermine la constante de proportionnalité qui relie la tension délivrée par le tore à l'intensité du courant électrique transporté par le conducteur placé dans l'anneau intérieur du tore.

Habituellement, on effectue l'étalonnage directement sur le bobinage de mesure, à l'aide d'une source de courant électrique générant une intensité représentative des conditions réelles de mesure, soit par exemple plusieurs milliers d'ampères pour le transport électrique sous moyenne ou sous haute tension. On utilise également un transformateur de courant étalon ainsi qu'un shunt étalon lui aussi.

L'étalonnage direct pose le problème de la disponibilité de tels équipements, avec des conséquences économiques importantes. Le problème est encore plus aigu lorsque l'on désire ré-étalonner le tore installé sur site. L'injection dans le conducteur placé dans le l'anneau intérieur du tore, d'un courant de test connue avec une bonne précision se révèle délicate. De surcroît, l'encombrement du transformateur de courant étalon ne facilite pas son installation à proximité du tore.

Le bobinage de test permet de simuler un conducteur placé dans l'anneau intérieur du tore à partir d'une source de courant électrique bien plus faible que celle qui est nécessaire à un étalonnage direct.

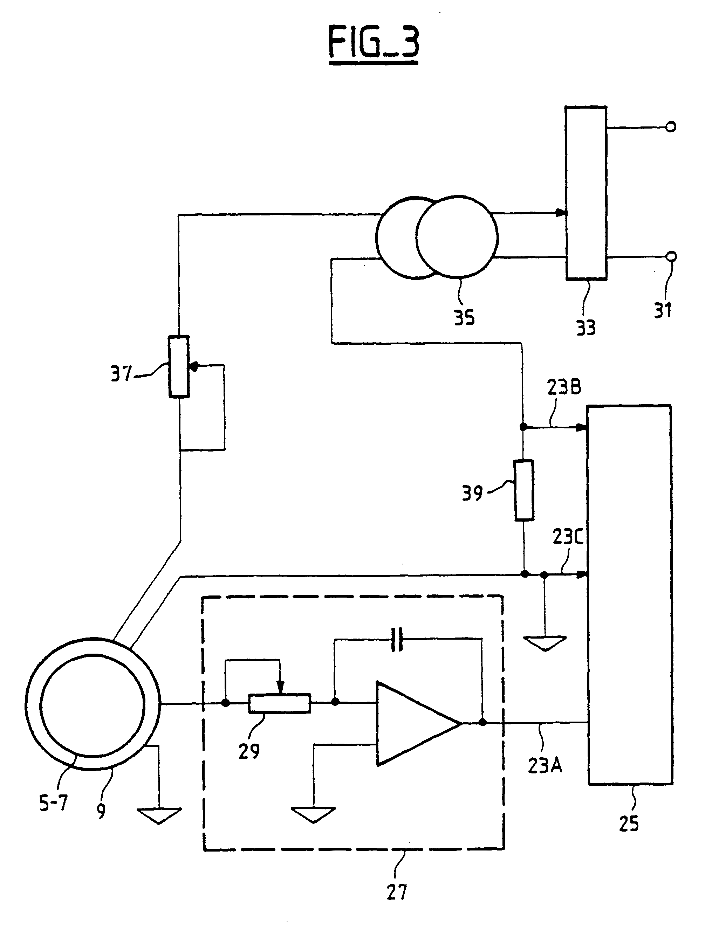

Sur la figure 3, on a représenté un montage permettant d'étalonner le tore. Le bobinage de mesure 5-7 est relié à une première voie 23A d'un amplificateur à verrouillage de phase 25 par l'intermédiaire d'un intégrateur 27 qui délivre une tension proportionnelle au courant transporté par le conducteur placé dans l'anneau intérieur du tore. Une résistance 29 de l'intégrateur permet de régler le gain de l'ensemble constitué par le tore et l'intégrateur.

Le bobinage de test 9 est relié à une source 31 à basse tension, par exemple en 220 volts, par l'intermédiaire d'un altemostat 33, d'un transformateur de tension 35, par exemple de 220 à 12 volts, et d'un rhéostat 37. Le transformateur de tension est relié à une deuxième voie 23B de l'amplificateur à verrouillage de phase. Une résistance de shunt 39 est montée entre le transformateur de tension et une masse 23C commune à l'amplificateur à verrouillage de phase et au bobinage de test du tore.

L'amplificateur à verrouillage de phase 25 permet de comparer la tension délivrée par le tore via l'intégrateur 27 avec la tension issue du shunt 39. On détermine la précision de mesure du tore par l'erreur sur l'amplitude et sur la phase de la tension délivrée.

Selon l'invention, en disposant d'un bobinage de test de 1000 spires, on simule dans le bobinage de mesure 5-7 un nombre d'ampères-tours équivalents à 1000 ampères, à partir d'une injection dans le bobinage de test 9 d'un courant de 1 ampère fourni par la source 31 via le transformateur de tension 35. On calcule le shunt 39 de façon à obtenir une tension de référence sensiblement égale à la tension délivrée par le tore, ce qui permet de ne pas utiliser de transformateur de courant étalon. Ainsi, l'étalonnage ou le réétalonnage sur site du tore est facilité par le bobinage de test.

Il faut noter que le bobinage de test permet d'étalonner l'ensemble constitué par le tore et l'intégrateur. De cette façon, on accède directement et simplement à la précision de mesure de l'ensemble tel qu'il est utilisé en service.

Le bobinage de test est également avantageux pour contrôler sur site le bon fonctionnement d'une chaîne constituée par le tore, l'intégrateur, et par exemple un relais de protection. Si le relais est réglé à une surintensité qui vaut 10 fois l'intensité nominale, on teste le fonctionnement du relais en injectant dans le bobinage de test un courant qui correspond dans le bobinage de mesure à une intensité comprise entre 10 et 12 fois l'intensité nominale. Le test du relais est ainsi effectué sans interruption de service.

## Revendications

1. Un bobinage torique sans noyau magnétique, du type d'un tore de Rogowski, qui comprend un support isolant (1) et un fil conducteur (3) qui est bobiné sur le support isolant suivant un certain sens de rotation (R) et d'une extrémité initiale (1l) à une extrémité finale (1F) du support (1) pour former un premier enroulement (5) de spires jointives (5A), ce fil conducteur (3) étant en outre bobiné sur le support isolant (1) suivant le même sens de rotation (R) et de l'extrémité finale (1F) vers l'extrémité initiale (1I) du support (1) pour former un deuxième enroulement (7) de spires jointives (7A) superposé au premier enroulement (5), **caractérisé en ce qu'**un deuxième fil conducteur (4) est bobiné autour du support (1) pour former un troisième enroulement (9) de spires superposé (9A) aux premier (5) et deuxième (7) enroulements, le deuxième (7) et le troisième (9) enroulements étant séparés par une gaine isolante (10), lesdits premier et second enroulement servant à la mesure du courant transporté par un conducteur placé dans le support isolant en forme de tore et le troisième enroulement étant destiné à être relié à une source de tension en vue de simuler la présence d'un tel conducteur.

2. Un bobinage selon la revendication 1, dans lequel le deuxième enroulement (7) est superposé au premier enroulement (5) de façon telle que chaque spire (7A) du deuxième enroulement s'appuie sur deux spires jointives (5A) du premier enroulement.

3. Un bobinage selon la revendication 1 ou 2, dans lequel les spires (9A) du troisième enroulement (9) sont espacées les unes des autres.

## Patentansprüche

1. Torusförmige Spule ohne magnetischem Kern, nach Art eines Rogowski-Kerns, einen isolierenden Träger (1) und einen leitenden Draht (3) umfassend, der entsprechend einer bestimmten Drehrichtung (R) und von einem Anfangsende (1I) zu einem Schlußende (1F) des isolierenden Trägers (1) so auf den Träger (1) gewickelt ist, dass er eine erste Wicklung (5) aus nebeneinanderliegenden Windungen (5A) bildet, wobei dieser leitende Draht (3) außerdem entsprechend derselben Drehrichtung (R) und von dem Schlussende (1F) zu dem Anfangsende (1I) des isolierenden Trägers (1) so auf den Träger (1) gewickelt ist, dass er auf der ersten Wicklung (5) eine zweite Wicklung (7) aus nebeneinanderliegenden Windungen (7A) bildet,
**dadurch gekennzeichnet,**
**dass** ein zweiter leitender Draht (4) so auf den Träger (1) gewickelt ist, dass er auf der ersten (5) und zweiten (7) Wicklung eine dritte Wicklung (9) aus Windungen (9A) bildet, wobei die zweite (7) und die dritte (9) Wicklung durch eine isolierende Hülle (10) getrennt sind, die erste und die zweite Wicklung dem Messen des Stroms dienen, der in einem Leiter fließt, welcher sich in dem torusförmigen isolierenden Träger befindet, und die dritte Wicklung dazu bestimmt ist, mit einer Spannungsquelle verbunden zu werden, um das Vorhandensein eines solchen Leiters zu simulieren.

2. Spule nach Anspruch 1, bei der die zweite Wicklung (7) derartig über der ersten Wicklung (5) angeordnet ist, dass jede Windung (7A) der zweiten Wicklung sich auf zwei nebeneinanderliegenden Windungen (5A) der ersten Wicklung abstützt

3. Spule nach Anspruch 1 oder 2, bei der die Windungen (9A) der dritten Wicklung (9) Abstand voneinander haben.

## Claims

1. Toroidal coil, without a magnetic core, of the Rogowski type of coil, which comprises an insulating support (1) and a conductor wire (3) which is wound onto the insulating support following a specific direction of rotation (R) and from an initial end (1I) to a final end (1F) of the support (1) to form a first winding (5) of close-wound coils (5A), this conductor wire (3) also being wound onto the insulating support (1) following the same direction of rotation (R) and from the final end (1F) to the initial end (1I) of the support (1) to form a second winding (7) of close-wound coils (7A), **characterised in that** a second conductor wire (4) is wound around the support (1) to form a third winding (9) of coils (9A) superimposed on the first (5) and second (7) windings, the second (7) and third (9) windings being separated by an insulating sheath (10), the said first and second windings being intended to measure the current transported by a conductor placed in the insulating support in the form of a coil, and the third winding being intended to be connected to a voltage source with a view to simulating the presence of such a conductor.

2. Coil according to claim 1, in which the second winding (7) is superimposed on the first winding (5) in such a way that each coil (7A) of the second winding rests on two close-wound coils (5A) of the first winding.

3. Coil according to claim 1 or 2, in which the coils (9A) of the third winding (9) are separated from each other.
